# EUROPEAN PATENT APPLICATION

(11) **EP 2 339 052 A1**
(43) Date of publication of application: **29.06.2011**
(21) Application number: 10194980.8
(22) Date of filing: 14.12.2010
(51) Int. Cl.: C30B 29/06, C30B 33/00, C30B 33/02, H01L 21/322

(54) **Silicon wafer and manufacturing method thereof**

(30) Priority: 28.12.2009 JP 2009298475
(71) Applicant: Siltronic AG, 81737 München (DE)
(72) Inventor: Matake, Tatsuhiko, 84489, Burghausen (DE)
(74) Representative: Staudacher, Wolfgang

(57) **Abstract**

To provide a manufacturing method of a silicon wafer, with which a desired strength and electric resistance of a semiconductor device can be obtained.

A non-oxidizing heat treatment for oxygen out-diffusion is performed on an intermediate 10 so as to manufacture a silicon wafer 1. The heat treatment for oxygen out-diffusion is a heat treatment wherein the desired amount of oxygen is discharged from the surface layer of the silicon substrate to the outside of the intermediate 10. By this heat treatment for oxygen out-diffusion, the surface layer 3 having a low oxygen content is formed on the silicon substrate 11. Here, the heat treatment of the silicon substrate 11 is performed through the oxide film 12.

## Description

The present invention relates to a silicon wafer and a manufacturing method thereof, wherein a heat treatment for controlling the surface oxygen concentration of the silicon wafer is performed. Particularly, the present invention relates to a silicon wafer with which in a semiconductor device, the desired strength and electric resistance can be obtained, and a manufacturing method of the silicon wafer wherein the heat treatment for controlling the surface oxygen concentration of the silicon wafer is performed.

Conventionally, crystal originated particles (COPs), which are void defects, exist on a silicon substrate formed in wafering process after a silicon single crystal ingot. Since the COPs may deteriorate the characteristics and yield of a device, silicon wafers have been manufactured by annealing the silicon substrate so as to annihilate the COPs (see, for example, JP Patent Application Publication No. 10-098047).

Further, conventionally, silicon wafers have been manufactured by inhibiting the generation of the COPs in a silicon single crystal ingot (see, for example, JP Patent Application Publication No. 8-330316).

However, in such an annealed silicon wafer, the oxygen as well as the surface defects of the annealed silicon wafer is diffused out by annealing, and therefore the amount of oxygen remaining on the surface of the manufactured silicon wafer decreases. Especially, since the annealing under argon ambience is a heat treatment under inert gas atmosphere, the amount of oxygen remaining on the surface of the silicon wafer is remarkably decreased, for example, to 1.0 x 10¹⁷ atoms/cm³ (ASTM F121-83) or less. When the oxygen content of the silicon wafer is remarkably decreased like this, a distortion is generated due to the stress around the device structure, which may result in an operation failure or a characteristic failure of the device.

Meanwhile, an annealing is not required for the silicon wafer, which is pulled by special condition that can control COP-size so as to become harmless on device performance. The oxygen content of the silicon wafer remains that of the silicon single crystal ingot, i.e. 4.0 x 10¹⁷ atoms/cm³ (ASTM F121-83) or more, which is inherent oxygen content of a silicon single crystal ingot. However, in the heat treatment during the wiring process of the silicon wafer, oxygen and silicon react, forming SiOx, which is an electrically active thermal donor. Although the electric resistance of the silicon wafer is set at a desired value, the electric resistance of the silicon wafer increases due to the resultant donor. Accordingly, the semiconductor device manufactured from the silicon wafer formed from a silicon single crystal ingot, wherein the generation of COPs is inhibited, has the problem of improper interconnection materials at device back end-process. Recently, the wiring materials have changed in order to achieve the miniaturization or high integration of semiconductor devices such as flash memories, and thereby, the heating treatment during the wiring process is performed under lower temperatures over longer periods of time. As the result, such thermal donors become more easily generated.

As described above, conventionally, the desired strength and electric resistance of a semiconductor device cannot be obtained.

In order to solve the above problem, the object of the present invention is to provide a silicon wafer and a manufacturing method thereof, with which the desired strength and electric resistance of a semiconductor device can be obtained.

In order to achieve the above object, the manufacturing method of the silicon wafer according to the present invention is characterized in that an oxide film is formed on the surface of the wafer prior to the heat treatment during which surface oxygen is out-diffused, so as to obtain the surface oxygen concentration of the silicon wafer of 2.0 x 10¹⁷ to 3.5 x10¹⁷ atoms/cm³ (ASTM F121-83) .

Preferably, the thickness of the oxide film is formed to, at the completion of the heat treatment for out-diffusion, be that of a native oxide film thickness (about 10 Å).

Further, in order to achieve the above object, the silicon wafer according to the present invention is characterized in having an oxygen concentration at the center of the wafer of 4.0 x 10¹⁷ atoms/cm³ or more and a surface oxygen concentration of 2.0 x 10¹⁷ to 3.5 x 10¹⁷ atoms/cm³ (ASTM F121-83).

Preferably, the thickness of the surface layer having the above surface oxygen concentration is at least 3 µm.

According to the manufacturing method of the silicon wafer of the present invention, the oxide film is formed on the surface of the silicon substrate, and when the surface oxygen of the silicon substrate is out-diffused, the heat treatment is performed through the oxide film. Accordingly, the amount of oxygen to be diffused from the silicon substrate by the heat treatment can be adjusted. Thereby, the residual oxygen content of the surface layer of the manufactured silicon wafer can be adjusted at a desired value. Therefore, the desired strength and electric resistance of the semiconductor device can be obtained.

Further, according to the manufacturing method of the silicon wafer of the present invention, in the heating treatment for out-diffusion of the surface oxygen for adjusting the surface oxygen concentration of the silicon substrate, the oxide film is formed on the surface layer at the initial stage of the heat treatment process, and at the completion of the heat treatment process, the thickness of the oxide film is that of a native oxide film (about 10 Å) . Therefore, no special post-treatment for removing the oxide film is required.

Further, according to the silicon wafer of the present invention, since the surface layer comprises the predetermined oxygen concentration, the difference in the electric resistance due to the heat treatment during the wiring process of the semiconductor device can be controlled within tolerance.
Fig. 1 shows the schematic constitution of the silicon wafer according to an embodiment of the present invention.
Fig. 2 shows the schematic constitution of an intermediate for manufacturing the silicon wafer in Fig. 1.

Hereinafter, an embodiment of the present invention will be described by referring to the drawings.

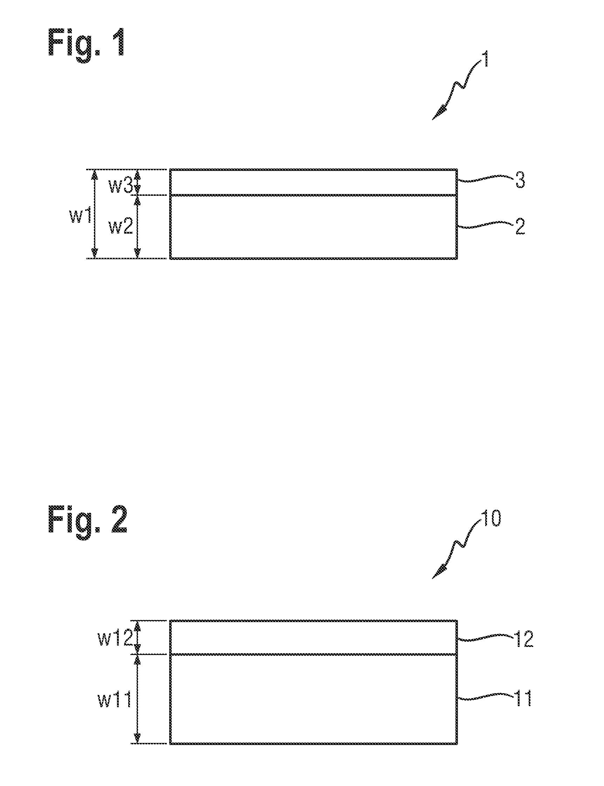

As shown in Fig. 1, the silicon wafer 1 comprises a base 2 and a surface layer 3 formed on the base 2. The silicon wafer 1 is a silicon wafer wherein the heat treatment of the silicon wafer for out-diffusion of the surface oxygen, described below, is performed to the silicon substrate which is formed by wafer-processing from a silicon single crystal ingot, so as to obtain a prescribed oxygen concentration.

The surface layer 3 has a prescribed oxygen concentration so as to obtain a desired strength and electric resistance of the semiconductor device manufactured by processing the silicon wafer 1. The prescribed oxygen concentration is, for example, 2.0 x 10¹⁷ to 3.5 x 10¹⁷ atoms/cm³ (ASTM F121-83).

The base 2 has the same oxygen content as the silicon single crystal ingot. The oxygen concentration of the base 2 is, for example, more than 4.0 x 10¹⁷ atoms/cm³. In the silicon wafer 1, the thickness w2 of the entire base 2 is, for example, 775 ± 25 µm (in case of a wafer diameter of 300 mm), and the thickness w3 of the surface layer 3 is at least 3 µm.

The method of controlling the oxygen concentration of the whole wafer to be within 2.0 x 10¹⁷ to 3.5 x 10¹⁷ atoms/cm³ (ASTM F121-83) by adjusting the crystal breeding conditions was reported before. However, in this case, the function of the base 2 (thickness: W2) as a structural material is not sufficient, i.e. the oxygen content is too small, so that there is the possibility that a wafer deformation is caused due to thermal stress during the front-end process of the device.

As described above, according to the silicon wafer 1 of the embodiment of the present invention, since the surface layer 3 has the prescribed oxygen concentration, the desired strength and electric resistance of the semiconductor device can be obtained, and the base 2 has sufficient oxygen in order to resist thermal stress or the like during the pre-process of the device.

The oxygen concentration of the surface layer 3 is lower than that of the silicon single crystal ingot of 2.0 x 10¹⁷ to 3.5 x 10¹⁷ atoms/cm³. Therefore, in the heat treatment during the manufacturing process of the silicon wafer 1 for the manufacturing of a semiconductor device, the electrically active SiOx is not formed to such an extent as to affect the device characteristics to a degree that would exceed tolerance. Accordingly, the increase in the electric resistance of the semiconductor device manufactured from the silicon wafer 1 can be prevented so as to maintain an allowable electric resistance after the wiring process of the semiconductor device. In addition, the desired strength of the semiconductor device can be obtained.

Next, an intermediate for manufacturing the silicon wafer 1 in Fig. 1 is described.

As shown in Fig. 2, the intermediate 10 for manufacturing the silicon wafer 1 comprises the silicon substrate 11 and the oxide film 12 formed on the surface of the silicon substrate 11.

The silicon substrate 11 is formed by wafer-processing a silicon single crystal ingot. The oxide film 12 is formed on the surface of the silicon substrate 11 formed by wafer-processing the silicon single crystal ingot. Therefore, the silicon substrate 11 contains oxygen in an amount of 4.0 x 10¹⁷ atoms/cm³ or more. The oxide film 12 requires a thickness capable of inhibiting, as desired, the out-diffusion of the surface oxygen of the silicon substrate 11 until the completion of the heat treatment. The thickness of the oxide film 12 is adjusted in accordance with the following heat treatment conditions.

In order to manufacture the silicon wafer 1 in Fig. 1, a non-oxidizing heat treatment for oxygen out-diffusion is performed to the intermediate 10. The above heat treatment for oxygen out-diffusion is a heat treatment wherein the desired content of oxygen is discharged from the surface layer of the silicon substrate 11 to the outside of the intermediate 10, so as to form a surface layer with low oxygen content on the silicon substrate 11. This surface layer is equivalent to the surface layer 3 of the silicon wafer 1 in Fig. 1. At this time, the heat treatment of the silicon substrate 11 is performed through the oxide film 12. Accordingly, the amount of oxygen to be removed from the surface of the silicon substrate 11 can be adjusted by annealing as heat treatment for oxygen out-diffusion, and the remaining oxygen content of the surface layer 3 of the silicon wafer 1 can be adjusted to be at a prescribed oxygen concentration. Then, the oxide film 12 is removed so as to generate the silicon wafer 1.

In the intermediate 10, the oxide film 12 requires a thickness capable of inhibiting the out-diffusion of the surface oxygen from the silicon substrate 11 to a prescribed amount. It is desirable that, at the completion of the heat treatment process for oxygen out-diffusion, the thickness of the oxide film 12 is reduced to that of the native oxide film and thereby no special post-treatment is required.

In the case where a non-oxidizing heat treatment with maximum temperature of about 1125 C° is performed as heat treatment for oxygen out-diffusion, the thickness of the oxide film is, for example, 10 Å. The oxide film may be grown by adjusting the oxygen partial pressure in the gas during ramping-up step in the heat treatment. The oxide film inhibits the out-diffusion amount of the surface oxygen and also prohibits the roughness of the wafer surface under non-oxidizing atmosphere.

## Claims

1. Manufacturing method of silicon wafer **characterized in that** an oxide film is formed on the surface of a wafer prior to a heat treatment during which surface oxygen is out-diffused, so as to obtain a surface oxygen concentration of the silicon wafer of 2.0 x 10¹⁷ to 3.5 x 10¹⁷ atoms/cm³ (ASTM F121-83).

2. Manufacturing method of silicon wafer according to claim 1, **characterized in that** the thickness of said oxide film is formed to, at the completion of the heat treatment for out-diffusion, be that of a native oxide film (about 10 Å).

3. Silicon wafer, **characterized in that** the oxygen concentration at the center of the wafer is 4.0 x 10¹⁷ atoms/cm³ or more and the surface oxygen concentration is in the range of 2.0 x 10¹⁷ to 3.5 x 10¹⁷ atoms/cm³ (ASTM F121-83).

4. Silicon wafer according to claim 3, **characterized in that** the thickness of the surface layer having said surface oxygen concentration is at least 3 µm.
